# EUROPEAN PATENT SPECIFICATION

(11) **EP 4 550 203 B1**
(45) Date of publication and mention of the grant of the patent: **29.04.2026**
(21) Application number: 23889859.7
(22) Date of filing: 19.09.2023
(51) Int. Cl.: G06F 30/327, G06F 13/12, G06F 13/16, H04L 47/62, G06F 3/06, G06F 9/38, G06F 9/30, G06F 16/174

(54) **REQUEST MERGING METHOD AND UNIT, AND CHIP**
VERFAHREN UND EINHEIT ZUR ZUSAMMENFÜHRUNG VON ANFRAGEN UND CHIP
PROCÉDÉ ET UNITÉ DE FUSION DE REQUÊTES, ET PUCE

(43) Date of publication of application: 07.05.2025
(73) Proprietor: VeriSilicon Microelectronics (Shanghai) Co., Ltd., Shanghai 201203 (CN); Verisilicon Microelectronics (Hainan) Co., Ltd., Haikou, Hainan 570208 (CN); VeriSilicon Technology (Shanghai) Co., Ltd., Shanghai 201306 (CN); VeriSilicon Microelectronics (Nanjing) Co., Ltd., Nanjing, Jiangsu 210032 (CN); VeriSilicon Microelectronics (Chengdu) Co., Ltd., Chengdu, Sichuan 610041 (CN)
(72) Inventor: LU, Rong, Shanghai 201203 (CN); ZHANG, Huiming, Shanghai 201203 (CN); CHEN, Yongjun, Shanghai 201203 (CN); WANG, Chao, Shanghai 201203 (CN); WU, Jianbing, Shanghai 201203 (CN); LI, Yijun, Shanghai 201203 (CN); ZHANG, Wei, Shanghai 201203 (CN)
(74) Representative: Locas, Davide
(86) International application number: PCT/CN2023/119832
(87) International publication number: WO 2025/059873

(56) References cited:
- EP-B1- 3 460 669
- CN-A- 113 656 178
- CN-A- 113 867 801
- CN-A- 113 867 801
- CN-A- 114 416 397
- US-A1- 2007 079 044
- US-A1- 2015 046 662

## Description

### Technical Field

The present disclosure relates to the field of chip design, and more specifically, to a request coalescing method, unit, and chip.

### Background Art

A memory access instruction can include 32 requests, each request can access a different address in the memory, and different requests can access the same memory address, so after receiving the memory access instruction, duplicate requests for accessing the same memory address can be coalesced to obtain a coalesced memory access instruction.

Currently, requests in memory access instructions are coalesced using a comparator to compare one request with another to determine if the access addresses are the same for both. While a memory access instruction can include up to 32 requests, if a comparator is set between any two requests, relatively more comparators are required to coalesce a memory access instruction, and consequently, the circuitries of the comparator occupy a larger chip area.

CN113867801A discloses a known chip design and request coalescing method.

### Summary

In view of the foregoing, the present disclosure provides a request coalescing method, unit, and chip to reduce the chip area occupied by the circuitry for coalescing memory access instructions.

In the first aspect, embodiments of the present disclosure provide a request coalescing unit, comprising: a multiplexer, which is configured to determine a target request from a plurality of requests to be coalesced, wherein the target request is one of the plurality of requests selected in accordance with a predetermined condition; a comparator group, which is connected to the multiplexer, wherein the comparator group is configured to compare the target request with the plurality of requests individually, so as to determine a duplicate request of the plurality of requests that duplicates with the target request; a first logic circuit, which is connected to the multiplexer, wherein the first logic circuit is configured to output to the multiplexer the remaining requests in the plurality of requests other than the duplicate request and the target request, so as to repeat the comparison process until all of the plurality of requests have completed the comparison; and the multiplexer is further configured to output the target request to the outside of the request coalescing unit.

In embodiments of the present disclosure, a target request can be determined from the plurality of requests to be coalesced by the multiplexer, and after the comparator group compares the target request with the plurality of requests to be coalesced respectively, the first logic circuit outputs the rest of the requests other than the duplicate request to the multiplexer, and re-determines the comparison process of the target request until the comparison of the plurality of requests to be coalesced is completed. Compared to using comparators for comparison between any two requests, the embodiments of the present disclosure only need to set up comparators to compare the target request with the plurality of requests to be coalesced, and only need to use the number of comparators corresponding to the number of requests in the plurality of requests to be coalesced, which is much less than the number of comparators set up between any two requests. Therefore, the above-described request coalescing unit can effectively reduce the number of comparators used and reduce the chip area occupied by the request coalescing unit.

In an embodiment, each request comprises a request identification value, wherein the request identification value comprises a valid value and an invalid value, the valid value characterizes that the request corresponding to the request identification value is valid, and the invalid value characterizes that the request corresponding to the request identification value is invalid. The request coalescing unit further comprising: a second logic circuit, which comprises a third logic input and a second logic output, wherein the third logic input is used to input a request identification value corresponding to the plurality of requests. The second logic output is connected to a selection control terminal of the multiplexer, and the selection control terminal is used to configure the predetermined conditions. The second logic circuit is used to determine a target request identification value from a plurality of request identification values corresponding to the plurality of requests, wherein the target request identification value is a valid value, and the request corresponding to the target request identification value is the target request.

In embodiments of the present disclosure, a request identification value of a request can be input into the second logic circuit, and a target request identification value output from the second logic circuit is used as a condition for the multiplexer to determine the target request. The request identification value is smaller compared to setting a complete request as a preset condition, which may effectively reduce the amount of data to be processed for determining the target request, thereby improving the efficiency of determining the target request, and improving the efficiency of request coalescing.

In an embodiment, the request coalescing unit further comprises a processor, wherein the processor is connected to the selection input and the selection output of the multiplexer, and the processor is further connected to the third logic input. The processor is configured for extracting the request identification value corresponding to each request in the plurality of requests; and combining all the request identification values into a request identification vector, so as to determine the target request identification value from the request identification vector.

In embodiments of the present disclosure, the processor can combine the request identification values into a request identification vector, such that the request identification vector includes request identification values of a plurality of requests, whereby the plurality of request identification values can be determined when determining the target request identification vector from the request identification vector, which can effectively improve the efficiency of determining the effective identification values compared to determining the different request identification values one by one, thereby improving the efficiency of determining the target requests and improving the efficiency of the request coalescing.

In an embodiment, the processor is further configured that the order of the request identification values corresponding to each request in the request identification vector is the same as the order of each request in the plurality of requests.

In this embodiment, the processor arranges each request identification value in the request identification vector in the same order as the order in which each request is arranged in the plurality of requests, whereby a corresponding request can be determined from the plurality of requests based on the order of the request identification value in the request identification vector, thereby improving the efficiency in determining the target request and improving the efficiency of coalescing the plurality of requests.

In an embodiment, the first logic circuit is further used to modify the request identification value of each of the duplicate request and the target request to an invalid value.

In this embodiment, the first logic circuit modifies the request identification value of both the duplicate request and the target request to an invalid value, whereby the duplicate request and the target request will no longer be selected as a new target request for subsequent comparisons, thereby reducing the likelihood that the same request or the duplicate request will be repeatedly selected as the target request for comparisons, in order to increase the accuracy and the efficiency of determining the target request, thus increasing the efficiency of request coalescing.

In an embodiment, the request coalescing unit further comprises a 2-to-1 selector (selector selecting one out of two), wherein the 2-to-1 selector comprises a second selection input, a third selection input and a second selection output. The second selection input is connected to a first logic output of the first logic circuit; the third selection input is used to input a request identification value corresponding to each of the plurality of requests to be coalesced; and the second selection input is connected to the third logic input. The 2-to-1 selector is configured to output the input signal of the second selection input when both the second selection input and the third selection input have inputs.

In this embodiment, the 2-to-1 selector is configured to output an input signal from the second selection input in the case that both the second selection input and the third selection input have inputs. The second selection input is connected to a first logic output, and the output of the first logical terminal is the remaining requests excluding duplicate requests and target request. Therefore, the 2-to-1 selector prioritizes outputting the requests that have not been compared, whereby the likelihood of the requests of repeated comparison can be reduced, thereby improving the efficiency of the request coalescing.

In the second aspect, embodiments of the present disclosure provide a chip, comprising the request coalescing unit as described in any one of the first aspects.

In the third aspect, embodiments of the present disclosure provide an electronic device, comprising a chip as described in the second aspect.

In the fourth aspect, embodiments of the present disclosure provide a request coalescing method, comprising: determining a target request from the plurality of requests to be coalesced, wherein the target request is one of the plurality of requests selected according to a predetermined condition. The target request is compared with the plurality of requests separately based on a predetermined comparator group, so as to determine the duplicate request of the plurality of requests that duplicates with the target request. The duplicate request comprises the target request. Based on the remaining requests of the plurality of requests other than the duplicate requests, the above comparison process is repeated until all of the plurality of requests have completed the comparison, and the target requests are output.

In embodiments of the present disclosure, by selecting a request as a target request from the plurality of requests to be coalesced, and after comparing the target request with the rest of the requests in the plurality of requests, the target request is re-determined until the comparison of all of the requests is completed, whereby a comparator needs to be set up only when a comparison is made between the target request and the plurality of requests, such that the number of comparators can be the same as the number of requests in the plurality of requests, and there is no need to set up a comparator between any two requests, thereby effectively reducing the number of comparators and reducing the area of chip occupied by the comparator.

In an embodiment, each request comprises a request identification value, wherein the request identification value comprises a valid value and an invalid value. The valid value characterizes the request corresponding to the request identification value as valid, and the invalid value characterizes the request corresponding to the request identification value as invalid. The step of selecting a target request from the plurality of requests to be coalesced comprises: determining a target request identification value from a plurality of the request identification values, wherein the target request identification value is a valid value; and identifying a request corresponding to the target request identification value as the target request.

In embodiments of the present disclosure, the request identification value has a smaller amount of data compared to a complete request, and therefore, using the request identification value to determine a target request can reduce the amount of data processed in determining the target request, and improve the speed of determining the target request, thereby improving the efficiency of the request coalescing.

In an embodiment, before the determining a target request identification value from the plurality of the request identification values, the method further comprises: extracting a request identification value corresponding to each request in the plurality of requests; and combining all the request identification values into a request identification vector, so as to determine the target request identification value from the request identification vector.

In the embodiments of the present disclosure, the request identification values are combined into a request identification vector, such that the request identification vector includes request identification values of a plurality of requests, whereby, when determining a target request identification vector from the request identification vector, the plurality of request identification values can be determined, and the efficiency of determining effective identification values can be effectively improved, compared to determining different request identification values one by one, thereby improving the efficiency of determining the target request and improving the efficiency of the request coalescing.

In one embodiment, the request identification values corresponding to each request are arranged in the same order as that of each request arranged in the plurality of requests, in the request identification vector.

In this embodiment, the order in which each request identification value in the request identification vector is arranged is the same as the order in which each request is arranged among the plurality of requests, whereby a corresponding request can be determined from the plurality of requests based on the order of the request identification value in the request identification vector, thereby improving the efficiency in determining a target request and improving the efficiency of coalescing the plurality of requests.

In an embodiment, after determining the duplicate request that duplicates the target request in the plurality of requests, the method further comprises: modifying the request identification value of each of the duplicate requests and the target request to an invalid value.

In this embodiment, the request identification values of both the duplicate request and the target request are modified to invalid values, whereby the duplicate request and the target request will no longer be selected as a new target request for subsequent comparisons, thereby reducing the likelihood that the same request or the duplicate request will be repeatedly selected as a target request for comparisons, in order to increase the accuracy and the efficiency of determining the target request, thereby increasing the efficiency of the request coalescing.

In an embodiment, the request comprises a request address, wherein the step of the determining a duplicate request that duplicates the target request in the plurality of requests comprises: inputting the request address of the target request and the request address of the plurality of requests into the comparator group separately, so as to make the comparator group compare the request address of the target request with the request address of the plurality of requests to be coalesced; obtaining an output result of the comparator group, wherein the output result characterizes whether the request address of the target request is the same as the request address of the plurality of requests to be coalesced; and determining the duplicate request based on the output result.

The main difference between different requests is that the request addresses are different, and therefore, in this embodiment, the request address can be used to determine whether the request is a duplicate request. Request addresses are easier to be processed compared to complete requests, and therefore, comparing request addresses improves the efficiency of determining duplicate requests, thereby improving the efficiency of request coalescing.

### Brief Description of Drawings

In order to more clearly illustrate the technical solutions of the embodiments of the present disclosure, the following will briefly introduce the drawings that are required to be used in the embodiments of the present disclosure. It should be understood that the following drawings only show certain embodiments of the present disclosure, and therefore should not be regarded as a limitation of the scope, and that the person of ordinary skill in the art can obtain other relevant drawings based on these drawings without making any inventive effort.
FIG. 1 is a structural schematic view of a request coalescing unit provided in an embodiment of the present disclosure;
FIG. 2 is a structural schematic view of a request coalescing unit provided in another embodiment of the present disclosure; and
FIG. 3 is a flowchart of a request coalescing method provided by an embodiment of the present disclosure.

Reference numerals: multiplexer 110; comparator group 120; first logic circuit 130; second logic circuit 140; 2-to-1 selector 150.

### Detailed Description of Embodiments

In order to make the objects, technical solutions and advantages of the present disclosure more clearly understood, the following is a further detailed description of the present disclosure in conjunction with the drawings and embodiments. It should be understood that the specific embodiments described herein are intended only to explain the present disclosure and are not intended to limit the present disclosure.

In order to facilitate understanding of the present disclosure, the memory instructions are described before the embodiments of the present disclosure are described.

Requests are issued when data are interacted between different modules or electronic devices, and multiple requests may be issued at the same time, which may be the same or different. For example, when some modules need to access the memory, a memory access instruction is issued, wherein the memory access instruction includes a plurality of requests, and different requests may access the same address within the memory space, so requests for access to the same address can be coalesced to reduce the number of requests in the memory access instruction. Exemplarily, some memory access instructions can be a shader group, wherein the shader group includes 32 thread requests, each of which includes an access address to a memory space, and different thread requests within the same shader group may include the same access address, so multiple thread requests with the same access address can be coalesced into a single cache line, and a shader group including 32 threads can be coalesced into a memory access instruction with less than 32 cache lines.

When performing the coalescing of memory access instructions, the requests in the memory access instructions can be compared using a comparator, so as to identify requests for the same access address, and the requests for the same access address can be coalesced using a logic gate circuit. Some memory access instructions include more memory instructions. For example, if the shader group includes 32 thread requests and a comparator is set between any two thread requests, more comparators need to be set; for example, if the 32 threads include thread0 to thread31, 31 comparators need to be set for comparing thread0 to thread1-thread31, then 30 comparators need to be set for comparing thread1 to thread2-thread31, and so on, in total, hundreds of comparators are needed. Too many comparators can take up a larger area of chip.

The present disclosure provides a request coalescing unit and a method in which a request is selected from a plurality of requests by setting a multiplexer, and the same request is determined by comparing the request with the remaining requests among the plurality of requests using a comparator group, whereby only the same number of comparators as the number of requests for the memory access instruction need to be set after the multiplexer. The number of comparators required by the present disclosure is less compared to a circuit comprising hundreds of comparators, and the chip area occupied by the comparators and the multiplexer is much less than that occupied by the hundreds of comparators, so as to achieve a reduction of chip area occupied by the request coalescing unit.

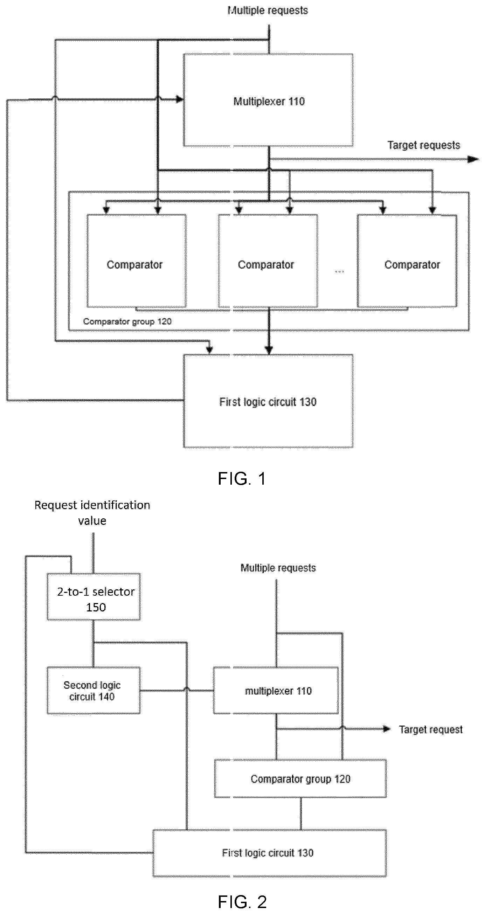

Referring to FIG. 1, FIG. 1 is a structural schematic view of a request coalescing unit provided in an embodiment of the present disclosure. The request coalescing unit includes multiplexer 110, comparator group 120, and first logic circuit 130.

The multiplexer 110, includes a selection control terminal, a selection output, and a selection input.

In this embodiment, the selection input can be used to input the plurality of requests to be coalesced. In some embodiments, the multiplexer 110 can include a plurality of selection inputs, wherein different selection inputs are used to input different requests. In other embodiments, the multiplexer 110 can include only one selection input, wherein different requests are input into that selection input in sequence. The foregoing are examples only, and are not intended to be a limitation of the present disclosure.

The difference between different requests usually lies in the difference of the request addresses, for example, the main difference between different requests in the memory access instruction lies in the different access addresses to the memory space. Therefore, in some embodiments, the request addresses corresponding to different requests can be input into the selection input, and the amount of data of the request addresses are smaller as compared to the complete request. Therefore, the workload when comparing the multiple requests can be reduced, thereby improving the efficiency of coalescing the multiple requests.

The selection control terminal is used for setting an output condition, and in this embodiment, the selection control terminal can set a predetermined condition for determining a target request from the plurality of requests.

In the embodiments of the present disclosure, since whether duplicate request exists or not is determined from a plurality of requests, each of request needs to be compared to each other. Therefore, the predetermined conditions can be that, from the plurality of requests, any of the remaining requests that are not identified as duplicate requests in the plurality of requests is identified as the target request. The selection input can input conditions characterizing duplicate requests among the plurality of requests, so as to cause the multiplexer 110 to select a target request from the remaining requests other than the duplicate request.

The selection output is configured to output the result of the selection for the plurality of requests.

In this embodiment, the multiplexer 110 is used to select a target request, then the selection output outputs the selection result as a target request.

In this embodiment, corresponding multiplexer 110 can be used depending on the number of requests in the plurality of requests. For example, when the plurality of requests to be coalesced includes 8 requests, an 8-to-1 selector can be selected, and when the plurality of requests to be coalesced includes 32 requests, a 32-to-1 selector can be selected. In some embodiments, the multiplexer 110 can also be obtained by combining a plurality of selectors, e.g., the 32-to-1 selector can include two 16-to-1 selectors and one 2-to-1 selector.

The principle and structure of the multiplexer 110 can be referred to the prior art, and will not be repeated here. The foregoing are examples only, and are not intended to be a limitation of the present disclosure.

The comparator group 120 includes a plurality of comparators.

As shown in FIG. 1, the comparator includes two inputs, including a first comparison input and a second comparison input, and a comparison output. The comparator can compare the input signals of the two inputs to get the comparison result, and output the comparison result through the comparison output.

In this embodiment, the first comparison inputs of the different comparators is connected to the selection output, and the second comparison inputs of the different comparators is each used to input a different request of the plurality of requests. As a result, the different comparators can compare the target request with different requests in the plurality of requests separately, thereby outputting a comparison result.

In embodiments of the present disclosure, the comparator group is configured to compare the target request with the plurality of requests to be coalesced respectively, so as to determine duplicate requests among the plurality of requests that duplicate the target request.

The comparison output of the comparator can output a comparison result characterizing whether the input signals of the two inputs are the same, and since the two inputs input one of the plurality of requests and the target request respectively, the comparison result can also be a duplicate request, or the comparison result can characterize whether the request in the plurality of requests is the same as the target request, i.e., the comparison result can characterize the output of the request in the plurality of requests as a duplicate request. For example, when the target request input by the first comparison input is the same as the request input by the second comparison input, the comparison output can output 0 or 1 , wherein 0 characterizes that the request input by the second comparison input is the same as the target request, i.e., the request input by the second comparison input is a duplicate request of the target request, and on the contrary, 1 characterizes that the request input by the second comparison input is different from the target request.

In this embodiment, the number of comparators in the comparator group 120 can be the same as the number of the plurality of requests to be coalesced. For example, if the number of requests to be coalesced is 32, 32 comparators can be set up in the comparator group 120, whereby the 32 requests including the target request can be separately input into different comparators, and separately compared with the target request to determine whether they are the same as the target request, thus the target request among the 32 requests and the duplicate request which is the same as the target request can be determined, so as to discontinue subsequent comparison of the target request and the duplicate request.

In some embodiments, the number of comparators in the comparator group 120 can be less than the number of the plurality of requests to be coalesced. For example, if the number of requests to be coalesced is 32, 31 comparators can be configured in the comparator group 120, and an additional selector is provided, wherein the input end of the additional selector sequentially inputs the plurality of requests to be coalesced, and the output end of additional selector is respectively connected to a different comparator of the comparator group 120, and the control end of additional selector is configured to sequentially output requests other than the target request among the plurality of requests to be coalesced to the different comparators for comparison.

The above is only an example and is not to be taken as a limitation of the present disclosure, the comparator group 120 can be reasonably combined according to the demand, and the principle and structure of the comparator can be referred to the prior art, and will not be repeated herein.

The first logic circuit 130 comprises a first logic input, a second logic input, and a first logic output.

In this embodiment, the first logic circuit 130 is configured to output content in the input signal of the second logic input other than the input signal of the first logic input, e.g., if the input signal of the first logic input is 0-3 and the input signal of the second logic input is 0-10, the first logic output may output 4-10.

In this embodiment, the above-described first logic circuit 130 can be implemented by logic gates, for example, using AND gates to implement the functionality of the first logic circuit 130. The first logic circuit 130 can be formed simply by removing the signal inputs from the first logic input from the signal inputs from the second logic input, and the person of ordinary skill in the art can use a combination of existing logic devices such as AND gates, NOT gates, OR gates, etc., according to the actual need, and will not be expanded herein.

In this embodiment, the first logic input can be connected to a comparison output, and a plurality of requests can be input to the second logic input. As a result, the first logic gate circuit can compare the plurality of requests with the duplicate requests output from the comparison output, and reject the duplicate requests among the plurality of requests. For example, when the comparison output outputs a characterization value of 0 or 1 that characterizes whether the request is a duplicate request, requests with a value of 0 can be rejected and requests with a value of 1 can be output normally.

In this embodiment, the first logic output is connected to the selection control terminal, whereby the first logic circuit 130 can output the remaining requests of the plurality of requests to be coalesced after the duplicate requests have been eliminated to the multiplexer 110, so as to cause the multiplexer 110 to select the target request again, such that the comparator compares the target request to be selected again with the remaining requests until all of the plurality of requests to be coalesced have been eliminated.

Since the non-repetitive requests access to different addresses in the memory space, the different requests have no need to be output at the same time, and therefore, in some optional embodiments of the present disclosure, the multiplexer 110, for each target request identified, can directly output the target request to the request coalescing unit, so as to access the memory space in accordance with the target request.

In some embodiments, the request coalescing unit can further comprise a buffer, wherein the buffer is connected to the selection output. The buffer can temporarily store the target requests output from the selection output, and after the comparison of the plurality of requests to be coalesced in the memory access instruction have all been completed, all of the target requests can be output outside the request coalescing unit for accessing the memory space in accordance with the target requests.

In embodiments of the present disclosure, the request includes an address for accessing the memory space, and in some embodiments, a request identification value can be configured for each request, for example, a request identification value of 1bit size can be configured for a thread request, wherein the request identification value can be identified as 0 or 1 to indicate whether or not the thread request is valid. When the request identification value is a 0, it characterizes that the thread request is invalid, and when the request identification value is a 1, it characterizes that the thread request is valid.

In embodiments of the present disclosure, the request identification value can be utilized to determine whether or not the request corresponding to the request identification value is a duplicate request or the comparison is completed. Accordingly, in some embodiments of the present disclosure, the request coalescing unit can further comprise a second logic circuit 140, wherein the second logic circuit 140 is used to input request identification values of the plurality of requests, and to determine a target request identification value from the request identification values, so as to output that target request identification value to the multiplexer 110. The multiplexer 110 can output the request corresponding to that target request identification value, i.e., the request corresponding to that target request identification value is the target request.

Referring to FIG. 2, FIG. 2 is a structural schematic view of a request coalescing unit provided in another embodiment of the present disclosure.

In an embodiment, the second logic circuit can further be configured to extract a request identification value corresponding to each request in the plurality of requests, and to combine all request identification values into a request identification vector, so as to determine a target request identification value from the request identification vector.

In this embodiment, the second logic circuit 140 can include a third logic input and a second logic output, wherein the third logic input can be used for inputting request identification values corresponding to the plurality of requests. The request identification values can be sequentially input into the third logic input, and the second logic circuit 140 can sequentially detect the request identification values, so as to output the order of the first request identification value that is a valid value. For example, if the request identification values of the eight requests are 0, 0, 1, 1, 0, 1, 1, 0 respectively, the second logic circuit 140 can output 3 to characterize the third request identification value as the target request identification value.

In this embodiment, the second logic output is coupled to the selection control terminal, so as to enable the target request identification value output from the second logic circuit 140 to be output to the multiplexer 110, as a condition for the multiplexer 110 to select the target request. For example, when the second logic circuit 140 outputs 3, multiplexer 110 can output the request with the order of 3 or the request input by the third request input.

In some embodiments, the request coalescing unit can include a processor, wherein the processor is coupled to a selection input and a selection output of the multiplexer 110, as well as the processor is further coupled to a third logic input. The processor can extract a request identification value from the plurality of requests and combine the request identification value into a request identification vector, so as to input the request identification vector into the second logic circuit 140.

In some embodiments, the processor can further be configured such that the request identification values corresponding to each request in the request identification vector are arranged in the same order as that of each request arranged in the plurality of requests. The implementation of the second logic circuit 140 described above can be constructed using existing logic circuits or with reference to prior art, for example, using leading one (a combinational logic module), which will not be described herein.

In an embodiment, the first logic circuit can further be used to modify the respective request identification values of both the duplicate request and the target request to an invalid value.

In this embodiment, the request identification vector or the plurality of request identification vectors can also be input into the second logic input of the first logic gate, so as to make the first logic circuit 130 perform a logic operation on the characterization value characterizing the duplicate request output from the comparator to modify the request identification value of the duplicate request to an invalid value, such that it does not participate in the next round of comparison. For example, if 00110011 is input to the second logic input and the value output to the first logic input by the comparator group 120 is 11011101, the first logic circuit 130 can output 00010001, wherein the third and seventh requests are duplicate requests, then the request identification values corresponding to the third and seventh requests can be modified to 0, such that they do not participate in the next round of comparison.

In one embodiment, the request coalescing unit can further comprise a 2-to-1 selector 150.

The initial request identification values or request identification vectors input to the second logic circuit 140 are valid values, i.e., all of the requests will be compared and the duplicate requests have not yet been identified. After completing a round of comparison, some of the requests are identified as duplicate requests, and the target requests have been identified. There is no need to compare the duplicate requests and the target requests again when conducting a new round of comparison, therefore, in the present embodiment, the 2-to-1 selector 150 can be configured to use the request identification values or the request identification vectors of the duplicate requests that have been identified as the inputs to the second logic circuit 140.

In this embodiment, the 2-to-1 selector 150 includes a second selection input, a third selection input, and a second selection output, wherein the second selection input is coupled to the first logic output, the third selection input is used to input a request identification value corresponding to each of the plurality of requests, and the second selection output is coupled to the third logic input. The 2-to-1 selector 150 can be configured to output the input signal from the second selection input in the event that both the second selection input and the third selection input have inputs.

As a result, when there is no input at the second selection input and there is an input at the third selection input, the input at the third selection input can be output. When there are inputs at both the second selection input and the third selection input, the input at the second selection input can be output. That is, when there is only an initial request identification vector, the initial request identification vector is output; and when the initial request identification vector and the modified request identification vector are input at the same time, the modified request identification vector is output, whereby each request will not be repeated for a number of times for comparison, thereby improving the efficiency of coalescing a plurality of requests.

Based on the same inventive concept, embodiments of the present disclosure further provide a request coalescing method.

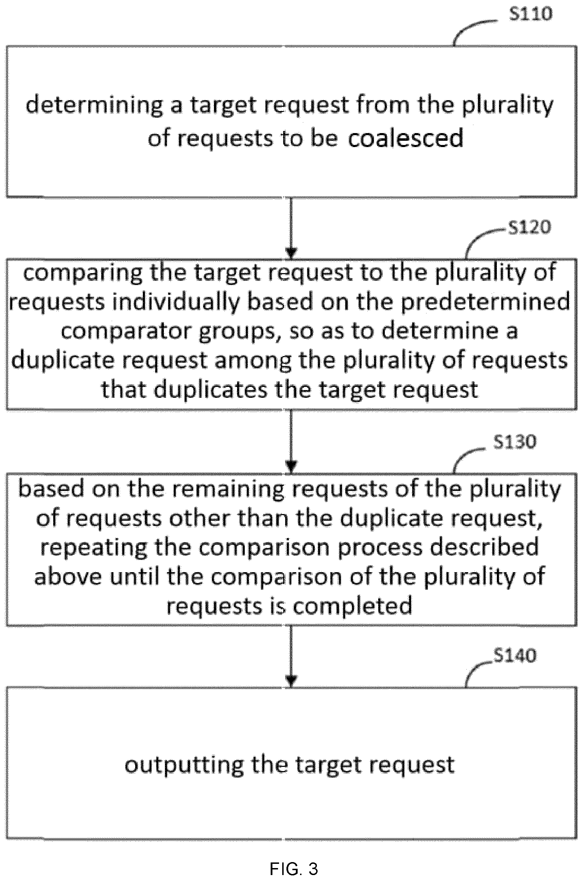

Referring to FIG. 3, FIG. 3 is a flowchart of a request coalescing method provided by embodiments of the present disclosure. The request coalescing method comprises following steps.

S110, determining a target request from the plurality of requests to be coalesced.

In this embodiment, the plurality of requests to be coalesced can be input into the multiplexer 110, so as to cause the multiplexer 110 to output a target request. The multiplexer 110 configures a predetermined condition for selecting a target request, wherein since the plurality of requests are required to determine whether to include a corresponding duplicate request, the predetermined condition is to identify any one of the plurality of requests that is not identified as a duplicate request or a target request as the target request.

In some embodiments, a corresponding request identification value can be set for each request, wherein the request identification value comprises a valid value and an invalid value, the valid value characterizes that the request corresponding to the request identification value is valid, and the invalid value characterizes that the request corresponding to the request identification value is invalid. As a result, the request identification value corresponding to a request which has not been determined to be a duplicate request or a target request can be identified as a valid value, and the request which has been determined to be a duplicate request or an invalid value is modified as an invalid value, so as to determine whether the request corresponding to the request is a duplicate request or has been determined to be a target request on the basis of the request identification value.

In some embodiments, selecting a target request from the plurality of requests to be coalesced can include: determining a target request identification value from the plurality of request identification values, wherein the target request identification value is a valid value; and determining the request corresponding to the target request identification value to be a target request.

In this embodiment, a request identification value corresponding to each request can be input into the second logic circuit 140, so as to make the second logic circuit 140 determine a target request identification value to output the target request identification value to the multiplexer 110, such that the multiplexer 110 can determine the request corresponding to the target request identification value as a target request.

In this embodiment, the second logic circuit 140 can determine the target request identification value by the request identification value corresponding to any of the valid values, and in some embodiments, the request identification value corresponding to the first valid value can be used to determine the target identification value as the order in which the request identification value is input into the second logic circuit 140. The above are examples only, but are not to be taken as limitations.

In some embodiments, after extracting the request identification values, all of the request identification values can also be combined into a request identification vector, so as to determine a target request identification value from the request identification vector.

When the number of requests to be coalesced is large, if each request identification value is sequentially input to the second logic circuit 140, it may take more time and affect the efficiency of the request coalescing. In this embodiment, the request identification values of different requests can be combined to obtain a request identification vector for inputting the request identification vector to the second logic circuit 140. Since the request identification vector includes the request identification values of a plurality of requests, the second logic circuit 140 can detect the request identification values of the plurality of requests in a shorter period of time without having to wait for the request identification values to be input sequentially, so that the efficiency of determining the target requests is improved, thereby improving the efficiency of coalescing the requests.

In some embodiments, in the request identification vector, the order of the request identification values corresponding to each request is the same as the order of each request in the plurality of requests.

Each request in the memory access instruction is arranged in order, and is sequentially input to the multiplexer 110 in the order of arrangement, and in this embodiment, the order of arrangement of the request identification value corresponding to each request can be the same as the order of arrangement of each request among the plurality of requests. As a result, after determining the target request identification value, the order of the target request identification value in the request identification vector can be directly output to the multiplexer 110, such that the multiplexer 110 outputs the requests of the plurality of requests in the corresponding order, i.e., the request corresponding to the request identification vector is determined to be the target request. As a result, a corresponding target request can be determined directly by the order in which the target request identification is arranged, thereby improving the efficiency of determining the target request and improving the efficiency of coalescing the requests.

S120, comparing the target request to the plurality of requests individually based on the predetermined comparator groups, so as to determine a duplicate request among the plurality of requests that duplicates the target request.

In this embodiment, the comparator group 120 includes a plurality of comparators, wherein a target request can be input into the first comparison inputs of all the comparators, and different requests can be input into the second comparison inputs of different comparators, thereby enabling comparison of the target request with the plurality of requests.

In this embodiment, the comparator can output a characterization value characterizing whether the request is the same as the target request. For example, the characterization value can be 0 and 1, wherein 0 characterizes the request the same as the target request, and 1 characterizes the request different from the target request.

By determining the target request through the multiplexer 110, and comparing the target request with other requests, the use of comparators can be effectively reduced, and there is no need to set up a comparator between any two requests, and it is only necessary to set up comparators between the target request and the other requests, and the number of comparators used can be reduced to the same number of requests of the plurality of requests to be coalesced, thereby reducing the chip area occupied by the comparators.

In some embodiments, a request address of the request can be input to the multiplexer 110, so as to cause the multiplexer 110 to output the request address, which is the address of the target request. Accordingly, determining a duplicate request that duplicates a target request among the plurality of requests can include: inputting the request address of the target request and the request addresses of the plurality of requests into the comparator group 120 separately, so as to cause the comparator group 120 to compare the request address of the target request with the request addresses of the plurality of requests to be coalesced; obtaining an output result of the comparator group 120, wherein the output result characterizes whether or not the request address of the target request is the same as the request address of the plurality of requests to be coalesced; and determining a duplicate request based on the output result.

In this embodiment, since the request is an access to the memory space, the access is based on the access address, i.e., the request address, the difference between the requests is mainly the difference in the request address. Therefore, the request can be input into the multiplexer 110 and the comparator group 120, so as to compare the request address to determine the duplicate request.

In this embodiment, the requested request address can be input into the multiplexer 110, which in turn uses the requested request address for comparison, thereby reducing the amount of data that the comparator needs to compare and improving the processing efficiency of the comparator.

S130, based on the remaining requests of the plurality of requests other than the duplicate request and the target request, repeating the comparison process described above until the comparison of the plurality of requests is completed.

In this embodiment, after determining the duplicate request, the first logic gate can send the duplicate request and the target request to the multiplexer 110, so as to duplicate S110 and S120, i.e., to cause the multiplexer to select from the plurality of requests other than the duplicate request and the target request for output to re-determine a new target request to be compared again, thereby determining the duplicate request that is duplicated with the new target request until all of the requests in the plurality of requests have been determined to be either a duplicate request or a target request, and then it can be determined that the plurality of requests have completed the comparison.

S140, outputting the target request.

In this embodiment, it is possible to output all the target requests after all the requests have completed the comparison, or it is possible to output the target requests after S110, and no further limitation is made herein.

In embodiments of the present disclosure, the request coalescing method can be applied to a processor, chip, module, electronic device, etc. that is connected to the request coalescing unit or includes the above-described request coalescing unit, and in some embodiments, the request coalescing method can also be applied to a hardware structure having a similar function of the above-described request coalescing unit, and the request coalescing unit is only an example, but is not to be taken as a limitation.

The contents not described in the request coalescing method can be referred to the description of the request coalescing unit described in the foregoing or to the prior art, and will not be expanded herein.

In embodiments of the present disclosure, by selecting one request from the plurality of requests to be coalesced as the target request, the target request is compared with the remaining requests in the plurality of requests, after that the target request is re-determined until the comparison of all the requests is completed. As a result, it is possible to set the comparator only when the target request and the plurality of requests are compared, such that the number of comparators can be the same as the number of requests in the plurality of requests, and it is not necessary to set the comparator between any two requests, thereby effectively reducing the number of comparators and reducing the chip area occupied by the comparator.

Based on the same inventive concept, embodiments of the present disclosure further provide a chip that can include the request coalescing unit provided in any of the above embodiments.

In this embodiment, the chip can be a CPU (Central Processing Unit), GPU (Graphics Processing Unit), MCU (Microcontroller Unit), and so on, and will not be limited herein.

Based on the same inventive concept, embodiments of the present disclosure also provide an electronic device, which can include the chip provided in the above embodiments

In this embodiment, the electronic device can be a computer, a server, a monolithic device, an embedded device, etc., without limitation herein.

It is to be noted that, as used herein, the terms "including", "comprising", or any other variant thereof, are intended to cover non-exclusive inclusion, such that a process, method, article, or apparatus comprising a set of elements includes not only those elements, but also other elements that are not expressly enumerated, or that are inherent to such process, method, article or apparatus. Without further limitation, the fact that an element is defined by the phrase "including a..." does not exclude the existence of another identical element in the process, method, article, or apparatus including the element.

## Claims

1. A request coalescing unit, **characterized in that** the request coalescing unit comprises:
a multiplexer (110), which is configured to determine a target request from a plurality of requests to be coalesced, wherein the target request is one of the plurality of requests selected according to predetermined conditions;
a comparator group (120), which is connected to the multiplexer (110), wherein the comparator group (120) is configured to compare the target request with the plurality of requests respectively, so as to determine a duplicate request in the plurality of requests that duplicates the target request; and
a first logic circuit (130), which is connected to the multiplexer (110), wherein the first logic circuit (130) is configured to output to the multiplexer (110) remaining requests of the plurality of requests other than the duplicate request and the target request to repeat a comparison process until all of the plurality of requests have completed a comparison, wherein
the multiplexer (110) is further configured to output the target request outside of the request coalescing unit,
wherein every comparator in the comparator group (120) is pre-loaded with a different request of the plurality of requests, and
wherein the predetermined condition is to identify any one of the plurality of requests that is not identified as a duplicate request or a target request as the target request.

2. The request coalescing unit according to claim 1, wherein each request comprises a request identification value, wherein the request identification value comprises a valid value and an invalid value, wherein the valid value characterizes that a request corresponding to the request identification value is valid, and the invalid value characterizes that a request corresponding to the request identification value is invalid; the request coalescing unit further comprises:
a second logic circuit (140), which comprises a third logic input and a second logic output, wherein the third logic input is configured to input request identification values corresponding to the plurality of requests; the second logic output is connected to a selection control terminal of the multiplexer (110), and the selection control terminal is configured to configure the predetermined conditions; and
the second logic circuit (140) is configured to determine a target request identification value from a plurality of request identification values corresponding to the plurality of requests; the target request identification value is a valid value; and a request corresponding to the target request identification value is the target request.

3. The request coalescing unit according to claim 2, wherein the request coalescing unit further comprises a processor that is connected to a selection input and a selection output of the multiplexer (110),
and the processor is further connected to the third logic input; and
the processor is configured to extract a request identification value corresponding to each request in the plurality of requests, and combining all request identification values into a request identification vector to determine the target request identification value from the request identification vector.

4. The request coalescing unit according to claim 3, wherein the processor is further configured to make an order of the request identification values corresponding to each request the same as an order of each request in the plurality of requests, in the request identification vector.

5. The request coalescing unit according to claim 2, wherein the first logic circuit (130) is further configured to: modify a request identification value of each of the duplicate request and the target request to an invalid value.

6. The request coalescing unit according to claim 2, wherein the request coalescing unit further comprises: a 2-to-1 selector (150), wherein the 2-to-1 selecto (150) comprises a second selection input, a third selection input and a second selection output; the second selection input is connected to a first logic output of the first logic circuit (130);
the third selection input is configured to input a request identification value corresponding to each of the plurality of requests; and
the second selection output is connected to the third logic input; the 2-to-1 selector (150) is configured to output an input signal from the second selection input, when both the second selection input and the third selection input have input.

7. A chip, **characterized in that** the chip comprises the request coalescing unit according to any one of claims 1-6.

8. A request coalescing method, **characterized in that** the request coalescing method comprises:
determining a target request from a plurality of requests to be coalesced, wherein the target request is one of the plurality of requests selected according to predetermined conditions;
comparing the target request with the plurality of requests individually based on a predetermined comparator group (120) to determine duplicate requests among the plurality of requests that duplicate the target request; and
based on remaining requests of the plurality of requests other than the duplicate requests and the target request, repeating the above comparison process until all of the plurality of requests have all been compared; and
outputting the target request,
wherein every comparator in the comparator group is pre-loaded with a different request of the plurality of requests, and
wherein the predetermined condition is to identify any one of the plurality of requests that is not identified as a duplicate request or a target request as the target request.

9. The request coalescing method according to claim 8, wherein each request comprises a request identification value, wherein the request identification value comprises a valid value and an invalid value, the valid value characterizes that a request corresponding to the request identification value is valid, and the invalid value characterizes that a request corresponding to the request identification value is invalid; and
the selecting a target request from a plurality of requests to be coalesced comprises:
determining a target request identification value from a plurality of request identification values, wherein the target request identification value is a valid value; and
identifying a request corresponding to the target request identification value as the target request.

10. The request coalescing method according to claim 9, wherein the method, before determining a target request identification value from a plurality of request identification values, further comprises:
extracting a request identification value corresponding to each request in the plurality of requests; and
combining all request identification values into a request identification vector, so as to determine the target request identification value from the request identification vector.

11. The request coalescing method according to claim 10, wherein the request identification values corresponding to each request in the request identification vector are arranged in the same order as an order in which each request is arranged in the plurality of requests.

12. The request coalescing method according to claim 9, wherein after determining the duplicate requests that duplicate the target request among the plurality of requests, the method further comprises: modifying the request identification value of each of the duplicate requests and the target request to an invalid value

13. The request coalescing method according to any one of claims 9-12, wherein the request comprises a request address, and determining the duplicate requests that duplicate the target request among the plurality of requests comprises:
inputting a request address of the target request and request addresses of the plurality of requests into the comparator group (120)
separately, so as to cause the comparator group to compare the request address of the target request with the request addresses of the plurality of requests to be coalesced;
obtaining an output result of the comparator group (120), wherein the output result characterizes whether the request address of the target request is the same as the request addresses of the plurality of requests to be coalesced; and
determining the duplicate requests based on the output result.

## Patentansprüche

1. Einheit zum Zusammenführen von Anfragen, **dadurch gekennzeichnet, dass** die Einheit zum Zusammenführen von Anfragen aufweist:
- einen Multiplexer (110), der eingerichtet ist, um eine Zielanfrage aus einer Mehrzahl von zusammenzuführenden Anfragen zu bestimmen, wobei die Zielanfrage eine der Mehrzahl von Anfragen ist, die nach vorbestimmten Bedingungen ausgewählt werden;
- eine Komparatorgruppe (120), die mit dem Multiplexer (110) verbunden ist, wobei die Komparatorgruppe (120) eingerichtet ist, um die Zielanfrage jeweils mit der Mehrzahl von Anfragen zu vergleichen, um eine Duplikatanfrage in der Mehrzahl von Anfragen zu bestimmen, die die Zielanfrage dupliziert; und
- eine erste Logikschaltung (130), die mit dem Multiplexer (110) verbunden ist, wobei die erste Logikschaltung (130) eingerichtet ist, um die verbleibenden Anfragen der Mehrzahl von Anfragen, die nicht die Duplikatanfrage und die Zielanfrage sind, an den Multiplexer (110) auszugeben, um einen Vergleichsprozess zu wiederholen, bis alle der Mehrzahl von Anfragen einen Vergleich abgeschlossen haben, wobei der Multiplexer (110) ferner eingerichtet ist, um die Zielanfrage außerhalb der Einheit zum Zusammenführen von Anfragen auszugeben,
- wobei jeder Komparator in der Komparatorgruppe (120) mit einer anderen Anfrage aus der Mehrzahl von Anfragen vorbelegt ist, und
- wobei die vorbestimmte Bedingung darin besteht, eine beliebige der Mehrzahl von Anfragen, die nicht als Duplikatanfrage oder Zielanfrage identifiziert wurde, als Zielanfrage zu identifizieren.

2. Einheit zum Zusammenführen von Anfragen nach Anspruch 1, wobei jede Anfrage einen Anfrageidentifikationswert aufweist, wobei der Anfrageidentifikationswert einen gültigen Wert und einen ungültigen Wert aufweist, wobei der gültige Wert kennzeichnet, dass eine dem Anfrageidentifikationswert entsprechende Anfrage gültig ist, und der ungültige Wert kennzeichnet, dass eine dem Anfrageidentifikationswert entsprechende Anfrage ungültig ist;
- wobei die Einheit zum Zusammenführen von Anfragen ferner aufweist:
- eine zweite Logikschaltung (140), die einen dritten Logikeingang und einen zweiten Logikausgang aufweist, wobei der dritte Logikeingang eingerichtet ist, um Anfrageidentifikationswerte entsprechend der Mehrzahl von Anfragen einzugeben, der zweite Logikausgang mit einem Auswahlsteuerungsanschluss des Multiplexers (110) verbunden ist und der Auswahlsteuerungsanschluss eingerichtet ist, um die vorbestimmten Bedingungen einzurichten;
- und wobei die zweite Logikschaltung (140) eingerichtet ist, um einen Zielanfrageidentifikationswert aus einer Mehrzahl von Anfrageidentifikationswerten entsprechend der Mehrzahl von Anfragen zu bestimmen; wobei der Zielanfrageidentifikationswert ein gültiger Wert ist; und eine Anfrage, die dem Zielanfrageidentifikationswert entspricht, die Zielanfrage ist.

3. Einheit zum Zusammenführen von Anfragen nach Anspruch 2, wobei die Einheit zum Zusammenführen von Anfragen ferner einen Prozessor aufweist, der mit einem Auswahleingang und einem Auswahlausgang des Multiplexers (110) verbunden ist, und der Prozessor ferner mit dem dritten Logikeingang verbunden ist; und
wobei der Prozessor eingerichtet ist, um einen Anfrageidentifikationswert zu extrahieren, der jeder Anfrage in der Mehrzahl von Anfragen entspricht, und alle Anfrageidentifikationswerte zu einem Anfrageidentifikationsvektor zu kombinieren, um den Zielanfrageidentifikationswert aus dem Anfrageidentifikationsvektor zu bestimmen.

4. Einheit zum Zusammenführen von Anfragen nach Anspruch 3, wobei der Prozessor ferner eingerichtet ist, um eine Reihenfolge der Anfrageidentifikationswerte, die jeder Anfrage entsprechen, mit einer Reihenfolge jeder Anfrage in der Mehrzahl von Anfragen im Anfrageidentifikationsvektor gleichzusetzen.

5. Einheit zum Zusammenführen von Anfragen nach Anspruch 2, wobei die erste Logikschaltung (130) ferner eingerichtet ist, um: einen Anfrageidentifikationswert jeder Duplikatanfrage und Zielanfrage in einen ungültigen Wert zu ändern.

6. Einheit zum Zusammenführen von Anfragen nach Anspruch 2, wobei die Einheit zum Zusammenführen von Anfragen ferner aufweist: einen 2-zu-1-Selektor (150), wobei der 2-zu-1-Selektor (150) einen zweiten Auswahleingang, einen dritten Auswahleingang und einen zweiten Auswahlausgang aufweist; wobei der zweite Auswahleingang mit einem ersten Logikausgang der ersten Logikschaltung (130) verbunden ist;
wobei der dritte Auswahleingang eingerichtet ist, um einen Anfrageidentifikationswert einzugeben, der jeder der Mehrzahl von Anfragen entspricht; und
wobei der zweite Auswahlausgang mit dem dritten Logikeingang verbunden ist; wobei der 2-zu-1-Selektor (150) eingerichtet ist, um ein Eingangssignal vom zweiten Auswahleingang auszugeben, wenn sowohl der zweite Auswahleingang als auch der dritte Auswahleingang einen Eingang aufweisen.

7. Chip, **dadurch gekennzeichnet, dass** der Chip die Einheit zum Zusammenführen von Anfragen nach einem der Ansprüche 1 bis 6 aufweist.

8. Verfahren zum Zusammenführen von Anfragen, **dadurch gekennzeichnet, dass** das Verfahren zum Zusammenführen von Anfragen aufweist:
- Bestimmen einer Zielanfrage aus einer Mehrzahl von zusammenzuführenden Anfragen, wobei die Zielanfrage eine der Mehrzahl von Anfragen ist, die nach vorbestimmten Bedingungen ausgewählt werden;
- Vergleichen der Zielanfrage mit der Mehrzahl von Anfragen einzeln auf der Grundlage einer vorbestimmten Komparatorgruppe (120), um Duplikatanfragen unter der Mehrzahl von Anfragen zu bestimmen, die die Zielanfragen duplizieren; und
- Wiederholen des obigen Vergleichsprozesses auf der Grundlage der verbleibenden Anfragen der Mehrzahl von Anfragen, die keine Duplikatanfragen und keine Zielanfrage sind, bis alle Anfragen der Mehrzahl von Anfragen verglichen worden sind; und
- Ausgeben der Zielanfrage,
- wobei jeder Komparator in der Komparatorgruppe mit einer anderen Anfrage aus der Mehrzahl von Anfragen vorbelegt ist, und
- wobei die vorbestimmte Bedingung darin besteht, eine beliebige der Mehrzahl von Anfragen, die nicht als Duplikatanfrage oder Zielanfrage identifiziert wurde, als Zielanfrage zu identifizieren.

9. Verfahren zum Zusammenführen von Anfragen nach Anspruch 8, wobei jede Anfrage einen Anfrageidentifikationswert aufweist, wobei der Anfrageidentifikationswert einen gültigen Wert und einen ungültigen Wert aufweist, wobei der gültige Wert kennzeichnet, dass eine dem Anfrageidentifikationswert entsprechende Anfrage gültig ist, und der ungültige Wert kennzeichnet, dass eine dem Anfrageidentifikationswert entsprechende Anfrage ungültig ist; und Wobei das Auswählen einer Zielanfrage aus einer Mehrzahl von zusammenzuführenden Anfragen aufweist:
- Bestimmen eines Zielanfrageidentifikationswerts aus einer Mehrzahl von Anfrageidentifikationswerten, wobei der Zielanfrageidentifikationswert ein gültiger Wert ist; und
- Identifizieren einer Anfrage, die dem Zielanfrageidentifikationswert entspricht, als Zielanfrage.

10. Verfahren zum Zusammenführen von Anfragen nach Anspruch 9, wobei das Verfahren vor dem Bestimmen eines Zielanfrageidentifikationswerts aus einer Mehrzahl von Anfrageidentifikationswerten ferner aufweist:
- Extrahieren eines Anfrageidentifikationswerts, der jeder Anfrage in der Mehrzahl von Anfragen entspricht; und
- Kombinieren aller Anfrageidentifikationswerte in einem Anfrageidentifikationsvektor, um den Zielanfrageidentifikationswert aus dem Anfrageidentifikationsvektor zu bestimmen.

11. Verfahren zum Zusammenführen von Anfragen nach Anspruch 10, wobei die Anfrageidentifikationswerte, die jeder Anfrage im Anfrageidentifikationsvektor entsprechen, in derselben Reihenfolge angeordnet sind wie die Reihenfolge, in der jede Anfrage in der Mehrzahl von Anfragen angeordnet ist.

12. Verfahren zum Zusammenführen von Anfragen nach Anspruch 9, wobei das Verfahren nach dem Bestimmen der Duplikatanfragen, die die Zielanfrage unter der Mehrzahl von Anfragen duplizieren, ferner aufweist: Ändern des Anfragenidentifikationswerts jeder der Duplikatanfragen und der Zielanfrage auf einen ungültigen Wert.

13. Verfahren zum Zusammenführen von Anfragen nach einem der Ansprüche 9 bis 12, wobei die Anfrage eine Anfrageadresse aufweist und ein Bestimmen der Duplikatanfragen, die die Zielanfrage unter der Mehrzahl von Anfragen duplizieren, aufweist:
- separates Eingeben einer Anfrageadresse der Zielanfrage und der Anfrageadressen der Mehrzahl von Anfragen in die Komparatorgruppe (120), um die Komparatorgruppe zu veranlassen, die Anfrageadresse der Zielanfrage mit den Anfrageadressen der Mehrzahl von zusammenzuführenden Anfragen zu vergleichen;
- Erhalten eines Ausgaberesultats der Komparatorgruppe (120), wobei das Ausgabenergebnis kennzeichnet, ob die Anfrageadresse der Zielanfragen mit den Anfrageadressen der Mehrzahl von zusammenzuführenden Anfragen übereinstimmt; und Bestimmen der Duplikatanfragen auf der Grundlage des Ausgaberesultats.

## Revendications

1. Unité de coalescence de requêtes, **caractérisée en ce que** l'unité de coalescence de requêtes comprend :
un multiplexeur (110), qui est configuré pour déterminer une requête cible à partir d'une pluralité de requêtes à fusionner, la requête cible étant l'une de la pluralité de requêtes sélectionnée selon des conditions prédéterminées ;
un groupe de comparateurs (120), qui est connecté au multiplexeur (110), dans lequel le groupe de comparateurs (120) est configuré pour comparer la requête cible avec la pluralité de requêtes respectivement, de manière à déterminer une requête dupliquée dans la pluralité de requêtes qui duplique la requête cible ; et
un premier circuit logique (130), connecté au multiplexeur (110), dans lequel le premier circuit logique (130) est configuré pour délivrer en sortie au multiplexeur (110) les requêtes restantes de la pluralité de requêtes autres que la requête dupliquée et la requête cible afin de répéter un processus de comparaison jusqu'à ce que toutes les requêtes de la pluralité de requêtes aient été comparées, dans laquelle
le multiplexeur (110) est en outre configuré pour délivrer en sortie la requête cible en dehors de l'unité de coalescence de requêtes,
dans laquelle chaque comparateur du groupe de comparateurs (120) est préchargé avec une requête différente de la pluralité de requêtes, et
dans laquelle la condition prédéterminée consiste à identifier comme requête cible l'une quelconque des requêtes de la pluralité de requêtes qui n'est pas identifiée comme une requête dupliquée ou une requête cible.

2. Unité de coalescence de requêtes selon la revendication 1, dans laquelle chaque requête comprend une valeur d'identification de requête, dans laquelle la valeur d'identification de requête comprend une valeur valide et une valeur invalide, dans laquelle la valeur valide caractérise qu'une requête correspondant à la valeur d'identification de requête est valide, et la valeur invalide caractérise qu'une requête correspondant à la valeur d'identification de requête est invalide ; l'unité de coalescence de requêtes comprend en outre :
un second circuit logique (140),
qui comprend une troisième entrée logique et une deuxième sortie logique, dans laquelle la troisième entrée logique est configurée pour entrer des valeurs d'identification de requête correspondant à la pluralité de requêtes ; la deuxième sortie logique est connectée à une borne de commande de sélection du multiplexeur (110), et la borne de commande de sélection est configurée pour configurer les conditions prédéterminées ; et
le second circuit logique (140) est configuré pour déterminer une valeur d'identification de requête cible à partir d'une pluralité de valeurs d'identification de requête correspondant à la pluralité de requêtes ; la valeur d'identification de requête cible est une valeur valide ;
et une requête correspondant à la valeur d'identification de requête cible est la requête cible.

3. Unité de coalescence de requêtes selon la revendication 2, dans laquelle l'unité de coalescence de requêtes comprend en outre un processeur qui est connecté à une entrée de sélection et à une sortie de sélection du multiplexeur (110), et le processeur est en outre connecté à la troisième entrée logique ; et
le processeur est configuré pour extraire une valeur d'identification de requête correspondant à chaque requête de la pluralité de requêtes, et pour combiner toutes les valeurs d'identification de requête en un vecteur d'identification de requête afin de déterminer la valeur d'identification de requête cible à partir du vecteur d'identification de requête.

4. Unité de coalescence de requêtes selon la revendication 3, dans laquelle le processeur est en outre configuré pour que l'ordre des valeurs d'identification de requête correspondant à chaque requête soit le même que l'ordre de chaque requête dans la pluralité de requêtes, dans le vecteur d'identification de requête.

5. Unité de coalescence de requêtes selon la revendication 2, dans laquelle le premier circuit logique (130) est en outre configuré pour : modifier une valeur d'identification de requête de chacune de la requête dupliquée et de la requête cible en une valeur invalide.

6. Unité de coalescence de requête selon la revendication 2, dans laquelle l'unité de coalescence de requêtes comprend en outre : un sélecteur 2 vers 1 (150),
dans lequel le sélecteur 2 vers 1 (150) comprend une deuxième entrée de sélection, une troisième entrée de sélection et une deuxième sortie de sélection ; la deuxième entrée de sélection est connectée à une première sortie logique du premier circuit logique (130) ;
la troisième entrée de sélection est configurée pour entrer une valeur d'identification de requête correspondant à chacune de la pluralité de requêtes ; et
la deuxième sortie de sélection est connectée à la troisième entrée logique ; le sélecteur 2 vers 1 (150) est configuré pour délivrer en sortie un signal d'entrée à partir de la deuxième entrée de sélection lorsque la deuxième entrée de sélection et la troisième entrée de sélection reçoivent toutes deux une entrée.

7. Puce, **caractérisée en ce que** la puce comprend l'unité de coalescence de requêtes selon l'une quelconque des revendications 1 à 6.

8. Procédé de coalescence de requêtes, **caractérisé en ce que** le procédé de coalescence de requêtes comprend :
la détermination d'une requête cible à partir d'une pluralité de requêtes à fusionner, la requête cible étant l'une de la pluralité de requêtes sélectionnée en fonction de conditions prédéterminées ;
la comparaison de la requête cible avec la pluralité de requêtes individuellement sur la base d'un groupe de comparateurs prédéterminé (120) pour déterminer les requêtes dupliquées parmi la pluralité de requêtes qui dupliquent la requête cible ; et
en fonction des requêtes restantes de la pluralité de requêtes autres que les requêtes dupliquées et la requête cible, la répétition du processus de comparaison ci-dessus jusqu'à ce que toutes les requêtes de la pluralité de requêtes aient été comparées ; et
la délivrance en sortie de la requête cible,
dans lequel chaque comparateur du groupe de comparateurs est préchargé avec une requête différente de la pluralité de requêtes, et
dans lequel la condition prédéterminée consiste à identifier comme requête cible l'une quelconque des requêtes de la pluralité de requêtes qui n'est pas identifiée comme une requête dupliquée ou une requête cible.

9. Procédé de coalescence de requêtes selon la revendication 8, dans lequel chaque requête comprend une valeur d'identification de requête, dans laquelle la valeur d'identification de requête comprend une valeur valide et une valeur invalide, la valeur valide caractérise qu'une requête correspondant à la valeur d'identification de requête est valide, et la valeur invalide caractérise qu'une requête correspondant à la valeur d'identification de la requête est invalide ; et
la sélection d'une requête cible parmi une pluralité de requêtes à fusionner comprend :
la détermination d'une valeur d'identification de requête cible à partir d'une pluralité de valeurs d'identification de requête, la valeur d'identification de requête cible étant une valeur valide ; et
l'identification d'une requête correspondant à la valeur d'identification de requête cible comme étant la requête cible.

10. Procédé de coalescence de requêtes selon la revendication 9, dans lequel le procédé, avant de déterminer une valeur d'identification de requête cible à partir d'une pluralité de valeurs d'identification de requête, comprend en outre :
l'extraction d'une valeur d'identification de requête correspondant à chaque requête de la pluralité de requêtes ; et
la combinaison de toutes les valeurs d'identification de requête en un vecteur d'identification de requête, afin de déterminer la valeur d'identification de requête cible à partir du vecteur d'identification de requête.

11. Procédé de coalescence de requêtes selon la revendication 10, dans lequel les valeurs d'identification de requête correspondant à chaque requête dans le vecteur d'identification de requête sont disposées dans le même ordre que l'ordre dans lequel chaque requête est disposée dans la pluralité de requêtes.

12. Procédé de coalescence de requêtes selon la revendication 9, dans lequel, après avoir déterminé les requêtes dupliquées qui dupliquent la requête cible parmi la pluralité de requêtes, le procédé comprend en outre : la modification de la valeur d'identification de requête de chacune des requêtes dupliquées et de la requête cible en une valeur invalide.

13. Procédé de coalescence de requêtes selon l'une quelconque des revendications 9 à 12, dans lequel la requête comprend une adresse de requête, et la détermination des requêtes dupliquées qui dupliquent la requête cible parmi la pluralité de requêtes comprend :
l'introduction séparément dans le groupe de comparateurs (120) d'une adresse de requête de la requête cible et des adresses de requête de la pluralité de requêtes, de manière à amener le groupe de comparateurs à comparer l'adresse de requête de la requête cible avec les adresses de requête de la pluralité de requêtes à fusionner ;
l'obtention d'un résultat de sortie du groupe de comparateurs (120), dans lequel le résultat de sortie indique si l'adresse de requête de la requête cible est la même que les adresses de requête de la pluralité de requêtes à fusionner ; et
la détermination des requêtes dupliquées sur la base du résultat de sortie.
